# EUROPÄISCHE PATENTSCHRIFT

(11) **EP 2 278 616 B1**
(45) Veröffentlichungstag und Bekanntmachung des Hinweises auf die Patenterteilung: **05.09.2012**
(21) Anmeldenummer: 10006524.2
(22) Anmeldetag: 23.06.2010
(51) Int. Cl.: H01L 23/29

(54) **Leistungshalbleitermodul mit einem Sandwich mit einem Leistungshalbleiterbauelement**
High-power semiconductor module with a sandwich with a high-power semiconductor component
Module semi-conducteur de puissance doté d'un sandwich équipé d'un composant semi-conducteur de puissance

(30) Priorität: 22.07.2009 DE 102009034138
(43) Veröffentlichungstag der Anmeldung: 26.01.2011
(73) Patentinhaber: SEMIKRON Elektronik GmbH & Co. KG, 90431 Nürnberg (DE)
(72) Erfinder: Göbl, Christian, 90441 Nürnberg (DE); Stockmeier, Thomas, Dr., 91054 Erlangen (DE)

(56) Entgegenhaltungen:
- EP-A1- 2 028 216
- EP-A2- 1 906 443
- DE-A1- 3 640 801
- GB-A- 1 349 478
- GB-A- 2 284 301
- US-A- 5 543 363

## Beschreibung

Die Erfindung beschreibt ein Leistungshalbleitermodul mit mindestens einem ersten und einem zweiten Lastanschlusskörper, die mit externen Zuleitungen verbunden sind. Zwischen mindestens zwei dieser Lastanschlusskörper ist, vorzugsweise druckkontaktiert, ein Sandwich mit einem ersten Metallformkörper, einem Leistungshalbleiterbauelement und einem zweiten Metallformkörper angeordnet. Diese Einzelteile des Sandwiches sind stoffschlüssig und elektrisch leitend miteinander verbunden.

Den Stand der Technik bilden einerseits Leistungshalbleitermodule in Druckkontaktierung, bei denen auch die Kompontenten des Sandwiches kraftschlüssig miteinander verbunden sind. Eine einfach und daher grundlegende Ausgestaltung ist beispielhaft in der DE 100 22 341 A1 offenbart. Hierbei bilden zwei Metallschienen die beiden Lastanschlusskörper, zwischen denen ein Halbleiterbauelement angeordnet ist. Weiterhin weist das Leistungshalbleitermodul je Halbleiterbauelement eine Druckeinrichtung auf, die eine kraftschlüssig elektrisch leitende Verbindung zwischen den Lastanschlusskörpern und dem jeweiligen Leistungshalbleiterbauelement herstellt.

Hierbei ist weiterhin bekannt das jeweilige Leistungshalbleiterbauelement nicht direkt mit dem Lastanschlusskörper zu verbinden. Durch die unterschiedlichen Ausdehnungskoeffizienten des meist aus Silizium bestehenden Leistungshalbleiterbauelements und den meist aus Kupfer bestehenden Lastanschlusskörpern kommt es bei thermischer Beanspruchung zu Beschädigungen des Leistungshalbleiterbauelements. Um dies zu verhindern wird zwischen Lastanschlusskörper und Leistungshalbleiterbauelement gemäß dem Stand der Technik mindestens ein weiterer Metallkörper meist in Zylinderform mit einem Ausdehnungskoeffizient, der zwischen denjenigen seiner beiden Nachbarn liegt, angeordnet.

Aus der DE 100 65 495 A1 ist eine Zentriereinrichtung für ein Leistungshalbleiterbauelement bekannt durch die ein Leistungshalbleiterbauelement und zwei Metallformkörper konzentrisch zueinander angeordnet werden und gleichzeitig eine Montageeinheit bilden. Hierzu weist die zweiteilige rahmenartige Zentriereinrichtung eine Mehrzahl von Haltenasen auf, die ein Trennen des Sandwiches aus einem ersten Metallformkörper, einem Leistungshalbleiterbauelement und einem zweiten Metallformkörper verhindern. Zur drucklosen Anordnung der Zentriereinrichtung weisen die Lastanschlusskörper Ausnehmungen zur Aufnahme der Haltenasen auf. Das Leistungshalbleiterbauelement selbst ist in einer Nut der Zentriereinrichtung angeordnet. Alle Elemente werden durch die Zentriereinrichtung lose zueinander angeordnet und weisen eine gewisse Beweglichkeit zueinander sowohl lateral als senkrecht hierzu auf.

Weiterhin ist es seit langem beispielhaft gemäß der DE 34 14 065 C2 bekannt die einzelnen Komponenten eines derartigen Sandwiches stoffschlüssig miteinander zu verbinden. Hier hat sich als besonders dauerhaft haltbare Verbindung eine Drucksinterverbindung bewährt.

Nachteilig an den bekannten Ausgestaltungen von Leistungshalbleitermodulen ist es, dass meist die gesamte zum Stromfluss von einer ersten Hauptfläche zu einer zweiten Hauptfläche des Leistungshalbleiterbauelements zur Verfügung steht, allerdings zur Abfuhr der Verlustleistung in Form von Wärme nur eine geringer Querschnittsfläche bereit gestellt ist. Die Lastanschlusskörper weisen also einen geringeren Querschnitt als die zur Stromführung ausgebildetet Fläche des Leistungshalbleiterbauelements auf, wodurch die Wärmeabfuhr aus dem Leistungshalbleiterbauelement nicht ausreichend ist um dessen maximale Leistungsfähigkeit auch im Dauerbetrieb zu nutzten.

Die nicht vorveröffentlichte DE 10 2009 000 885 A1 offenbart ein spezielles Leistungshalbleitermodul, bei dem zumindest ein mit einem Substrat verbundenes halbleitendes Bauelement von einem aus einem Polymermaterial hergestellten Gehäuse umgeben ist, wobei das Polymermaterial eine aus einem präkeramischen Polymer gebildete duroplastische Matrix aufweist. Die mechanischen Eigenschaften eines derartigen Polymermaterials sind vornehmlich durch die Auswahl und Menge der Füllstoffe beeinflussbar, wodurch eine gelartige oder duroplaste Ausgestaltung möglich ist. Der besondere Vorzug dieses Polymermaterials liegt in der hohen thermischen Leitfähigkeit, wobei es selbstverständlich elektrisch isolierend ist.

Aus der DE 36 40 801 A1 ist ein Halbleiterbauelement mit einem Halbleiterelement, einem Paar Elektroden auf jeder Seite des Halbleiterelements und einem zylindrischen Bauteil, das das Halbleiterelement umgibt, bekannt.

Aus der GB 2 284 301 A ist eine Halbleitermodul bekannt, bei dem die elektrischen Verbindungen über Presskontakte hergestellt werden.

Aus der EP 2 028 216 A1 ist ein Verfahren zur Formgebung eines präkeramischen Polymers bekannt.

Der Erfindung liegt die Aufgabe zugrunde ein Leistungshalbleitermodul mit einem verbesserten inneren Aufbau vorzustellen, wodurch die Wärmeabfuhr aus einen Leistungshalbleiterbauelements verbessert wird.

Diese Aufgabe wird erfindungsgemäß gelöst, durch einen Gegenstand mit den Merkmalen des Anspruchs 1. Bevorzugte Ausführungsformen sind in den abhängigen Ansprüchen beschrieben.

Den Ausgangspunkt der Erfindung bilden Leistungshalbleitermodule der oben genannten Art mit mindestens einem ersten und einem zweiten Lastanschlusskörper. Zwischen einem ersten und einem zweiten Lastanschlusskörper ist mindestens ein Sandwich angeordnet, das eine Folge aus einem ersten Metallformkörper, einem Leistungshalbleiterbauelement und einem zweiten Metallformkörper aufweist.

Hierbei sind die Komponenten des Sandwiches stoffschlüssig miteinander verbunden und ein Randbereich des Leistungshalbleiterbauelements ist von einem elektrisch isolierenden, hoch wärmeleitfähigen Polymermaterial umschlossen. Vorzugsweise ist dieser Randbereich gebildet aus einem ersten und zweiten Rand einer jeweils zugeordneten Hauptfläche des Leistungshalbleiterbauelements sowie dem hierzwischen ausgebildeten Mantelbereich des Leistungshalbleiterbauelements, wobei der Mantelbereich durchaus eine Struktur, wie sie von MESA Bauelementen bekannt ist aufweisen kann.

Erfindungsgemäß ist dieses Polymermaterial in thermisch leitendem Kontakt zu mindestens einem, vorzugsweise beiden, dem ersten oder zweiten Metallformkörper, um die Wärme effektiv von dem Leistungshalbleiterbauelement abtransportieren zu können. Hierbei kann es weiterhin bevorzugt sein, wenn das Polymermaterial in thermischem Kontakt mit dem Gehäuse des Leistungshalbleitermoduls steht, weil hierdurch der Wärmabtransport nochmals deutlich verbessert werden kann. Um das Sandwich besonders einfach zu dem Gehäuse anzuordnen ist es bevorzugt wenn das Gehäuse eine teilweise trichterförmige Aussparung aufweist und das Sandwich in dieser Aussparung angeordnet ist.

Es ist weiterhin vorteilhaft, dass das Polymermaterial ein präkeramisches Polymer ist, wobei hierunter ein Polymer verstanden werden soll, welches z. B. mit zunehmender Temperatur zunächst in einen gelartigen und nachfolgend in einen duroplastischen Zustand übergeht. Im duroplastischen Zustand weist ein präkeramisches Polymer in der Regel eine Temperaturbeständigkeit von bis zu 300°C auf. Bei einer weiteren Temperaturerhöhung können aus präkeramischen Polymeren keramische Werkstoffe hergestellt werden. Zu diesen präkeramischen Polymeren gehören beispielsweise Polysilane, Polycarbosilane und Polyorganosilizane.

Zur Ausbildung des gelartigen oder duroplasten Zustands ist das präkeramische Polymer zudem mit einem Füllgrad von bis zu 80 Vol.% mit einem Füllstoff gefüllt. Als bevorzugter Füllstoff hat sich ein aus einem keramischen Material gebildetes Pulver mit einer mittleren Komgröße im Bereich von 0,5 bis 50 µm erwiesen, wobei das keramische Material aus der folgenden Gruppe ausgewählt ist: BN, SiC, Si3N4, AIN, Steatit, Cordierit. Mit einer derartigen Ausgestaltung ist eine Wärmeleitfähigkeit γ des keramischen Materials bei Raumtemperatur von größer als 10 W/mK, im Bedarfsfall auch größer als 20 W/mK erzielbar.

Besonders bevorzugte Weiterbildungen des erfindungsgemäßen Leistungshalbleitermoduls sind in der jeweiligen Beschreibung der Ausführungsbeispiele genannt. Die erfinderische Lösung wird zudem an Hand der Ausführungsbeispiele der Fig. 1 bis 3 weiter erläutert.

Fig. 1 zeigt eine Ausgestaltung eines ersten erfindungsgemäßen Leistungshalbleitermoduls in dreidimensionaler Ansicht sowie im Querschnitt.

Fig. 2 zeigt einen Ausschnitt eines zweiten erfindungsgemäßen Leistungshalbleitermoduls.

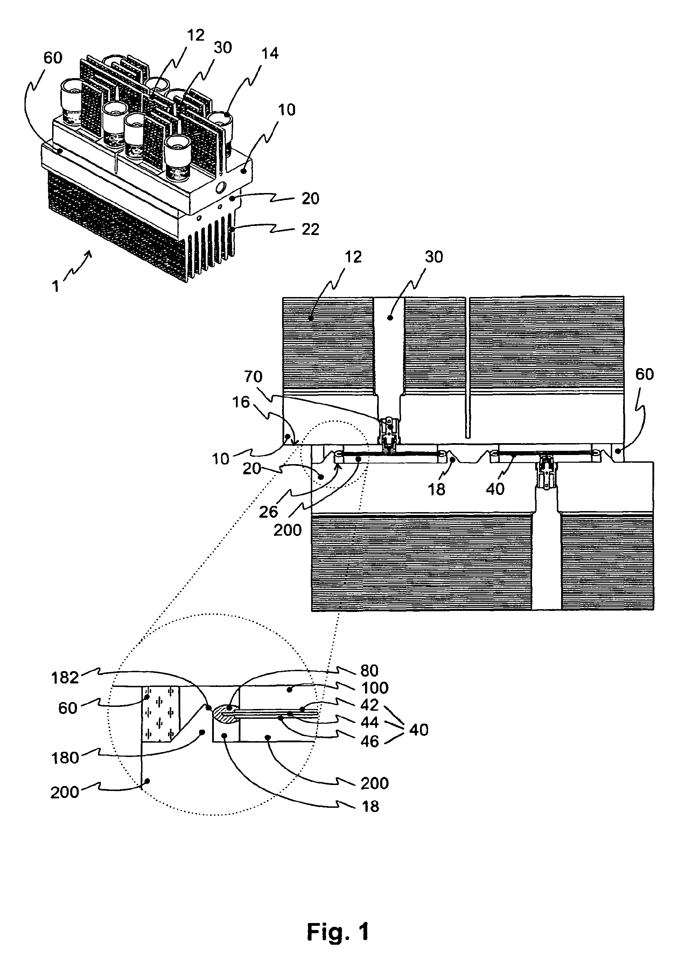

Fig. 1 zeigt ein erfindungsgemäßes Leistungshalbleitermodul (1) in dreidimensionaler Ansicht sowie im Querschnitt. Das Leistungshalbleitermodul (1) weist einen ersten (10) und einen zweiten Lastanschlusskörper (20) sowie erste (100) und zweite Verbindungseinrichtungen (200) auf, zwischen denen zwei Sandwiches (40) mit jeweils einem Leistungshalbleiterbauelement (44), hier einem Thyristor, angeordnet und antiparallel verschaltet sind. Die elektrische Kontaktierung (70) der beiden Sandwiches erfolgt mittels Kraftschluss mittels einer Druckkontaktierung zwischen den beiden Lastanschlusskörpern (10; 20). Hierzu weist das Leistungshalbleitermodul (1) pro Sandwich vier Schraubverbindungen (14) jeweils mit einer Mehrzahl von Tellerfedern auf. Weiterhin sind die beiden Lastanschlusskörper (10; 20) hier jeweils einstückig mit zugeordneten Kühleinrichtungen (12; 22) verbunden. Zur Abdichtung weist das Leistungshalbleitermodul (1) noch einen umlaufenden seitlich mit dem Lastanschlusselementen (10, 20) abschließende Dichteinrichtung (60) aus einem elektrisch isolierenden Material, vorzugweise ebenfalls einem Polysiloxan auf.

Das jeweilige Sandwich (40), bestehend aus einem Stapel aus einem ersten Metallformkörper (42), dem jeweiligen Thyristor (44) und einem zweiten Metallformkörper (46), wobei diese Komponenten stoffschlüssig, beispielhaft mittels einer Drucksinterverbindung, miteinander verbunden sind. Weiterhin weist die erste Verbindungseinrichtung (100), wie auch der erste Metallformkörper (42) je eine Ausnehmung fluchtend mit der Steueranschlussfläche des Thyristors (44) auf. In dieser Ausnehmung (30) ist eine Kontakteinrichtung (70) angeordnet. Diese Kontakteinrichtung (70) liegt mit einer Anschlagkante auf der Oberfläche der ersten Verbindungseinrichtung (100) auf.

Das Leistungshalbleiterbauelement (44) des jeweiligen Sandwiches (40) ist erfindungsgemäß im Randbereich von einem elektrisch isolierenden, hoch wärmeleitfähigen Polymermaterial umschlossen, wodurch ein erster (440) und zweiter Rand (442) der jeweils zugeordneten Hauptfläche (446, 448) des Leistungshalbleiterbauelements (44) sowie der hierzwischen ausgebildeten Mantelbereich (444) von dem Polymermaterial (80) bedeckt ist.

Weiterhin ist ersichtlich, dass das Polymermaterial in thermisch leitendem Kontakt zu beiden, dem ersten (42) und dem zweiten Metallformkörpern (46) ist um eine Wärmeabfuhr aus dem Leistungshalbleiterbauelement (44) auf die Metallformkörper (42, 46) zu verbessern.

Weiter verbessert wird diese Wärmeabfuhr durch zumindest geringfügigen Kontakt des Polymermaterials (80) auch mit mindestens einem Lastanschlusselement (100, 200) oder mit mindestens einem Lastanschlusskörper (20). Dieser Lastanschlusskörper weist hierzu eine durch einen zylindermantelartig begrenzten Aufnahmebereich (18) auf, wobei der zylinderartige Mantel (180) gebildet wird aus einem Fortsatz des Lastanschlusskörpers selbst. Dadurch, dass an der offenen Seite des Aufnahmebereichs (18) der Mantel zur Innenseite hin trichterförmig angephast (182) ist dient dieser Mantel (180) nicht nur der Wärmeübertragung sondern auch der Zentrierung des Sanwiches (40).

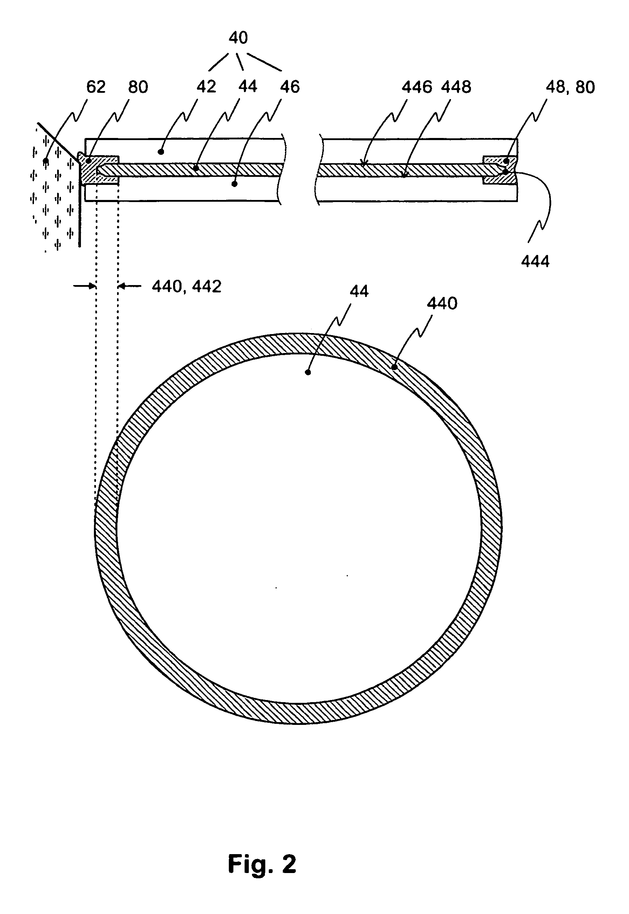

Fig. 2 zeigt einen Ausschnitt eines zweiten erfindungsgemäßen Leistungshalbleitermoduls, wobei hier außer dem Sandwich (40) nur ein Teil eines Gehäuses dargestellt ist, das aus einem elektrisch isolierenden, aber vorzugsweise gut Wärme leitenden Werkstoff besteht.

Das Sandwich 40 besteht aus einem Leistungshalbeiterbauelement (40) und kann hier als ein Transistor oder auch als eine Diode ausgebildet sein. An den jeweiligen Hauptflächen (446, 448) des Leistungshalbleiterbauelements (40), das hier ohne beschränkung der Allgemeinheit rund dargestellt ist, schließen sich die beiden Metallformkörper (42, 46) an. Zur stoffschlüssigen Verbindung der Komponenten des Sandwiches (40) hat sich eine Drucksinterverbindung als besonders vorteilhaft erwiesen.

Eine auf den Hauptflächen (446, 448) der Leistungshalbleiterbauelemente vorgesehene Kontaktfläche zur elektrisch leitenden Verbindung mit den Formkörpern reicht nicht bis an den Rand des Leistungshalbleiterbauelements heran, um elektrische Überschläge über diesen Randbereich auszuschließen. Daher sparen die elektrische Kontaktflächen einen jeweils einen äußeren Randbereich (440, 442) auf den Hauptflächen des Leistungshalbleiterbauelements frei, der von dem Polymermaterial derart umschlossen ist, dass auch der Mantelbereich (444) des Leistungshalbleiterbauelements (44) vollständig mit umschlossen ist.

Erfindungsgemäß ist diese Polymermaterial (80) auch in thermisch leitendem zu mindestens einem hier bevorzugt zu beiden Formkörpern (42, 46) ist. Diese Formkörper (42, 46) überragen hier den Rand des Leistungshalbleiterbauelements (44) lateral ohne direkt Kontakt zum dessen äußerem Randbereich (440, 442). In dieser hierdurch gebildeten das Sandwich (40) umlaufenden Öffnung (48) ist das Polymermaterial (80) derart angeordnet, dass es die Öffnung (48) überragt. Dies ist bevorzugt, weil hierdurch das Polymermaterial (80) zusätzlich in thermisch leitendem Kontakt zu einem Teil des Gehäuses (62) des Leistungshalbleitermoduls (1) stehen kann, wie im linken Teil von Fig. 2 dargestellt. Im rechten Teil von Fig. 2 ist eine alternative Ausgestaltung dargestellt bei die Öffnung (48) durch das Polymermaterial (80) nicht überragt wird.

Auch hier ist eine trichterförmige Aufnahme als Teil des Gehäuses (62) zur Positionierung des Sandwiches (40) derart vorgesehen, dass das Sandwich (40) durch eine den Trichter bildende Phase (620) am Rand der Aufnahme einfach in dieser Aufnahme angeordnet werden kann.

## Patentansprüche

1. Leistungshalbleitermodul (1) mit mindestens einem ersten (10) und einem zweiten Lastanschlusskörper (20), mit mindestens einem zwischen diesen Lastanschlusskörpern (10; 20) angeordnetem Sandwich (40) mit einem ersten Metallformkörper (42), einem Leistungshalbleiterbauelement (44) und einem zweiten Metallformkörper (46); wobei die Komponenten des Sandwiches (40) stoffschlüssig miteinander verbunden sind und ein Randbereich (440, 442, 444) des Leistungshalbleiterbauelements umschlossen ist von einem elektrisch isolierenden, hoch wärmeleitfähigen Polymermaterial (80) und wobei dieses Polymermaterial (80) in thermisch leitendem Kontakt zu mindestens dem ersten (42) oder zweiten Metallformkörper (46) ist, **dadurch gekennzeichnet, dass** das Polymermaterial (80) ein präkeramisches Polymer ist, wobei das präkeramische Polymer in gelartiger oder duroplastischer Form vorliegt.

2. Leistungshalbleitermodul (1) nach Anspruch 1,
wobei der Randbereich gebildet wird aus einem ersten (440) und zweiten äußeren Randbereich (442) einer jeweils zugeordneten Hauptfläche (446, 448) des Leistungshalbleiterbauelements (44) sowie dem hierzwischen ausgebildeten Mantelbereich (444) des Leistungshalbleiterbauelements (40).

3. Leistungshalbleitermodul (1) nach Anspruch 1,
wobei die elektrisch leitende Verbindung der Lastanschlusskörper (10, 20) mit dem Sandwich (40) kraftschlüssig ausgebildet ist.

4. Leistungshalbleitermodul (1) nach Anspruch 1,
wobei das leistungsnalbleitomodul (1) ein Gehäuse (62) aufweist und wobei das Polymermaterial (80) in thermischem Kontakt mit dem Gehäuse (62) des Leistungshalbleitermoduls (1) steht.

5. Leistungshalbleitermodul (1) nach Anspruch 1 oder 4,
wobei das Leistungshalbleitermodul (1) eine teilweise trichterförmige Aufnahme (18) aufweist und das Sandwich (40) in dieser Aufnahme (18) angeordnet ist.

6. Leistungshalbleitermodul (1) nach Anspruch 1,
wobei das präkeramische Polymer mit einem Füllgrad von bis zu 80 Vol.% mit einem Füllstoff gefüllt ist und dieser Füllstoff ein aus einem keramischen Material gebildetes Pulver mit einer mittleren Korngröße im Bereich von 0,5 bis 50 µm ist.

7. Halbleitermodul nach Anspruch 6, wobei die Wärmeleitfähigkeit γ des keramischen Materials bei Raumtemperatur größer als 10 W/mK, vorzugsweise größer als 20 W/mK, ist.

8. Leistungshalbleitermodul (1) nach Anspruch 6 oder 7,
wobei das keramische Material aus der folgenden Gruppe ausgewählt ist: BN, SiC, Si3N4, AIN, Steatit, Cordierit.

9. Leistungshalbleitermodul (1) nach Anspruch 1,
wobei das präkeramische Polymer aus der folgenden Gruppe ausgewählt ist: Polysiloxan, Polysilazan, Polycarbosilan.

## Claims

1. A power semiconductor module (1) with at least a first (10) and a second load connecting element (20), with at least one sandwich (40) arranged between these load connecting elements (10, 20), with a first shaped metal body (42), a power semiconductor component (44) and a second shaped metal body (46), wherein
the components of the sandwich (40) are connected with one another by means of material bonding, and an edge region (440, 442, 444) of the power semiconductor component is surrounded by an electrically insulating, high thermal conductivity polymer material (80), and wherein
this polymer material (80) is in thermally conducting contact with at least the first (42) or the second shaped metal body (46),**characterised in that** the polymer material (80) is a preceramic polymer, wherein
the preceramic polymer is present in the form of a type of gel or thermoplastic.

2. The power semiconductor module (1) in accordance with Claim 1, wherein
the edge region is formed from a first (440) and a second outer edge region (442) of a main surface (446, 448), associated in each case, of the power semiconductor component (44) and also from the jacket region (444), formed in between, of the power semiconductor component (40).

3. The power semiconductor module (1) in accordance with Claim 1, wherein
the electrically conducting connection of the load connecting elements (10, 20) with the sandwich (42) is designed as a force fit.

4. The power semiconductor module (1) in accordance with Claim 1, wherein
the power semiconductor module (1) has a housing (62), and wherein
the polymer material (80) is in thermal contact with the housing (62) of the power semiconductor module (1).

5. The power semiconductor module (1) in accordance with Claim 1 or 4, wherein
the power semiconductor module (1) has a partially funnel-shaped seating (18), and the sandwich (40) is arranged in this seating (18).

6. The power semiconductor module (1) in accordance with Claim 1, wherein
the preceramic polymer is filled with a filling level of up to 80% by volume with a filler material, and this filler material is a powder formed from a ceramic material with an average grain size in the range from 0.5 to 50 µm.

7. The semiconductor module in accordance with Claim 6, wherein
the thermal conductivity y of this ceramic material at room temperature is greater than 10 W/mK, preferably greater than 20 W/mK.

8. The power semiconductor module (1) in accordance with Claim 6 or 7, wherein
the ceramic material is selected from the following group: BN, SiC, Si3N4, AIN, steatite, cordient.

9. The power semiconductor module (1) in accordance with Claim 1, wherein
the preceramic material is selected from the following group: polysiloxane, polysilazane, polycarbosilane.

## Revendications

1. Module à semi-conducteurs de puissance (1) comprenant au moins un premier corps de branchement de charge (10) et un second de corps de branchement de charge (20), au moins un sandwich (40) disposé entre ces corps de branchement de charge (10 ; 20) avec un premier corps formé en métal (42), un composant à semi-conducteurs de puissance (44) et un second corps formé métallique (46), les composants du sandwich (40) étant reliés les uns aux autres par adhésion de matière et une zone de bordure (440, 442, 444) du composant à semi-conducteurs de puissance étant entourée par un matériau polymère (80) électriquement isolant et très thermoconducteur et ce matériau polymère (80) étant en contact thermoconducteur avec au moins le premier corps formé métallique (42) ou le second corps formé métallique (46), **caractérisé en ce que** le matériau polymère (80) est un polymère précéramique, le polymère précéramique étant présent sous forme de gel ou sous forme duroplastique.

2. Module à semi-conducteurs de puissance (1) selon la revendication 1,
la zone de bordure étant formée d'une première zone de bordure (440) et d'une seconde zone de bordure extérieure (442) d'une surface principale (446, 448) respectivement attribuée du composant à semi-conducteurs de puissance (44) et de la zone d'enveloppe (444) conçue entre ces zones du composant à semi-conducteurs de puissance (40).

3. Module à semi-conducteurs de puissance (1) selon la revendication 1,
la liaison électroconductrice des corps de branchement de charge (10, 20) étant conçue par adhérence de force avec le sandwich (40).

4. Module à semi-conducteurs de puissance (1) selon la revendication 1,
le module à semi-conducteurs de puissance (1) présentant un boîtier (62) et le matériau polymère (80) étant en contact thermique avec le boîtier (62) du module à semi-conducteurs de puissance (1).

5. Module à semi-conducteurs de puissance (1) selon la revendication 1 ou 4,
le module à semi-conducteurs de puissance (1) présentant un logement (18) partiellement en forme d'entonnoir et le sandwich (40) étant disposé dans ce logement (18).

6. Module à semi-conducteurs de puissance (1) selon la revendication 1,
le polymère précéramique étant rempli avec un degré de remplissage allant jusqu'à 80 % de volume avec une matière de charge et cette matière de charge étant une poudre formée à base d'un matériau céramique avec une grosseur de grain moyenne de l'ordre de 0,5 à 50 µm.

7. Module à semi-conducteurs de puissance selon la revendication 6, la conductibilité thermique y du matériau céramique étant supérieure à 10 W/mK, de préférence supérieure à 20 W/mK à la température ambiante.

8. Module à semi-conducteurs de puissance (1) selon la revendication 6 ou 7,
le matériau céramique étant choisi dans le groupe suivant : BN, SiC, Si3N4, AIN, stéatite, cordiérite.

9. Module à semi-conducteurs de puissance (1) selon la revendication 1,
le polymère précéramique étant choisi dans le groupe suivait :
polysiloxane, polysilasane, polycarbosilane.
